# EUROPEAN PATENT APPLICATION

(11) **EP 4 815 306 A1**
(43) Date of publication of application: **30.09.2026**
(21) Application number: 25165691.4
(22) Date of filing: 24.03.2025
(51) Int. Cl.: H03K 17/082, H03K 17/12, H03K 17/284, H03K 17/08, H03K 17/689

(54) **GATE DRIVE CIRCUIT, CIRCUIT ARRANGEMENT, METHOD**

(71) Applicant: Infineon Technologies Austria AG, 9500 Villach (AT); Politecnico Di Torino, 10129 Torino (IT)
(72) Inventor: PICCIONI, Andrea, 9580 Villach (AT); STELLA, Fausto, 14055 Motta di Costigliole, Asti (IT)
(74) Representative: Infineon Patent Department

(57) **Abstract**

A gate drive circuit for driving at least a first and a second power transistor between switching states, wherein the first and second power transistor are arranged in parallel between a first load node and a second load node, the gate drive circuit comprising: a control signal input node configured to receive a common control signal, temperature input nodes to receive a temperature signals indicative of a temperature of the power transistors, a delay determination unit configured to determine a delay signal comprising at least one of a turn-on delay value and a turn-off delay value based on a comparison of the temperatures of the first and second power transistors, a drive signal generation unit configured to generate a respective drive signals for driving the first and second power transistors based on the common control signal and the delay signal such that a time difference between a turn-on timing of the drive signals corresponds to the turn-on delay value and/or such that a time difference between a turn-off timing of the drive signals corresponds to the turn-off delay value, a first driver stage configured to provide the first drive signal at a first driving node and a second driver stage configured to provide the second drive signal at a second driving node.

## Description

### TECHNICAL FIELD

The present disclosure relates to gate drive circuits, circuit arrangements, and methods.

### BACKGROUND

Maximum load current of power transistors scales with the active area of the device. Thus, to support higher load current, devices with larger active area may be used. However, available processing technology may limit the maximum area that can be achieved with acceptable yield. Therefore, as an alternative to increasing the active area of an individual device, several devices may be connected in parallel, thereby increasing the maximum load current of the arrangement. This is done, for example, with silicon carbide (SiC) based metal oxide semiconductor field-effect transistors (MOSFET), to achieve a sufficiently high load current.

Although paralleling of devices is simple from a principle point of view, in practice some challenges occur, in particular in applications with high switching frequency, for which SiC MOSFETs are particularly suited. Based on local and/or temporal variations of process parameters during production, each individual die produced in a production line may have slightly varying properties (parameter spread). This may lead to slightly varying behavior of each power transistor in an application. In addition, a layout of an application circuit implementing the parallel power transistors may impact switching performance and current sharing between the devices. Such deviations between the devices may have adverse effects on the individual devices, such as increased aging, and may also negatively affect the overall system, such as the formation of hot spots, unbalanced wear, early downrating of power output, or reduced safe operating area.

Active gate driving methods may be used to mitigate the adverse effects described before. For example, an active gate drive scheme may be implemented that drives the individual devices using individual driving signals such that the devices exhibit a same behavior, such that a load current is balanced, for example. However, such active approaches require an essentially real-time feedback of certain parameters, such as the load current through each individual device or the voltage across each individual device and an essentially real-time control loop to adjust the individual gate driving signals. These solutions are therefore very complex and expensive.

In view of the above, there is a need to improve the control of paralleled power transistors.

### SUMMARY

One or more embodiments of the present disclosure provide a gate drive circuit for driving at least a first and a second power transistor between switching states, wherein the first and second power transistor are arranged in parallel between a first load node and a second load node, the gate drive circuit comprising: a control signal input node configured to receive a common control signal, a first temperature input node configured to receive a first temperature signal indicative of a temperature of the first power transistor, a second temperature input node configured to receive a second temperature signal indicative of a temperature of the second power transistor, a delay determination unit configured to determine a delay signal comprising at least one of a turn-on delay value and a turn-off delay value based on a comparison of the temperature of the first power transistor and the temperature of the second power transistor, a drive signal generation unit configured to generate a first drive signal for driving the first power transistor and a second drive signal for driving the second power transistor based on the common control signal and the delay signal such that a time difference between a turn-on timing of the first drive signal and a turn-on timing of the second drive signal corresponds to the turn-on delay value and/or such that a time difference between a turn-off timing of the first drive signal and a turn-off timing of the second drive signal corresponds to the turn-off delay value, a first driver stage configured to provide the first drive signal at a first driving node configured to be coupled to a control node of the first power transistor, and a second driver stage configured to provide the second drive signal at a second driving node configured to be coupled to a control node of the second power transistor.

One or more embodiments of the present disclosure relate to a method for determining drive signals for driving of a first and a second power transistor between switching states, wherein the first and second power transistor are arranged in parallel between a first load node and a second load node. The method comprises, in a first step, determining a temperature of the first power transistor and a temperature of the second power transistor, in a second step, determining a turn-on delay value and/or a turn-off delay value based on a comparison of the temperature of the first power transistor and the temperature of the second power transistor, and in a third step, determining a first drive signal corresponding to the first power transistor and a second drive signal corresponding to the second power transistor based on a common control signal such that a time difference between a turn-on timing of the first drive signal and a turn-on timing of the second drive signal corresponds to the turn-on delay value and/or a time difference between a turn-off timing of the first drive signal and a turn-off timing of the second drive signal corresponds to the turn-off delay value.

One or more embodiments of the present disclosure provide a primary gate drive circuit configured for driving a first power transistor between switching states, the primary gate drive circuit being specifically adapted to be used in combination with at least one secondary gate drive circuit according to one or more embodiments of the present disclosure that is configured for driving at least one second power transistor between switching states, wherein the first and at least one second power transistor are arranged in parallel between a first load node and a second load node. The primary gate drive circuit comprises a control signal input node configured to receive a common control signal, a first temperature input node configured to receive a first temperature signal indicative of a temperature of the first power transistor, at least one second temperature input node configured to receive a respective second temperature signal indicative of a temperature of the at least one second power transistor, a delay determination unit configured to determine a respective turn-on delay value corresponding to each respective one of the first power transistor and the at least one second power transistor, and/or a respective turn-off delay value corresponding to each respective one of the first power transistor and the at least one second power transistor, based on a comparison of the temperature of the first power transistor and the respective temperature of the at least one second power transistor, a communication interface configured to be coupled to a corresponding communication interface of the at least one secondary gate drive circuit and to transmit the respective turn-on delay value and/or the respective turn-off delay value to the at least one secondary gate drive circuit, a drive signal generation unit configured to generate a drive signal for driving the first power transistor based on the common control signal and the turn-on delay value and/or the turn-off delay value corresponding to the first power transistor such that a time difference between a turn-on timing of the common control signal and a turn-on timing of the drive signal corresponds to the turn-on delay value corresponding to the first power transistor and/or such that a time difference between a turn-off timing of the common control signal and a turn-off timing of the drive signal corresponds to the turn-off delay value corresponding to the first power transistor, and a driver stage configured to provide the drive signal at a driving node configured to be coupled to a control node of the first power transistor.

One or more embodiments of the present disclosure provide a secondary gate drive circuit configured for driving a second power transistor between switching states, the secondary gate drive circuit being specifically adapted to be used in combination with the primary gate drive circuit according to one or more embodiments of the present disclosure that is configured for driving a first power transistor between switching states, wherein the first and second power transistor are arranged in parallel between a first load node and a second load node. The secondary gate drive circuit comprises a control signal input node configured to receive a common control signal, a communication interface configured to be coupled to the communication interface of the primary gate drive circuit and to receive a turn-on delay value and/or a turn-off delay value, a drive signal generation unit configured to generate a drive signal for driving the second power transistor based on the common control signal and the turn-on delay value and/or the turn-off delay value such that a time difference between a turn-on timing of the common control signal and a turn-on timing of the drive signal corresponds to the turn-on delay value and/or such that a time difference between a turn-off timing of the common control signal and a turn-off timing of the drive signal corresponds to the turn-off delay value, and a driver stage configured to provide the drive signal at a driving node configured to be coupled to a control node of the second power transistor.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Fig. 1 illustrates a schematic block diagram of a first example implementation of a gate drive circuit in accordance with embodiments disclosed herein;
Fig. 2 illustrates a first schematic timing diagram according to embodiments disclosed herein;
Fig. 3 illustrates a second schematic timing diagram according to embodiments disclosed herein;
Fig. 4 illustrates a third schematic timing diagram according to embodiments disclosed herein;
Fig. 5 illustrates a fourth schematic timing diagram according to embodiments disclosed herein;
Fig. 6A and 6B each illustrate a schematic diagram including a respective temperature curve for two power transistors when operated in a parallel arrangement according to embodiments disclosed herein;
Fig. 7 illustrates a schematic block diagram of a second example implementation of a gate drive circuit in accordance with embodiments disclosed herein;
Fig. 8 illustrates a schematic block diagram of a third example implementation of a gate drive circuit in accordance with embodiments disclosed herein;
Fig. 9 illustrates a schematic block diagram of a fourth example implementation of a gate drive circuit in accordance with embodiments disclosed herein;
Fig. 10 illustrates a fifth schematic timing diagram according to embodiments disclosed herein;
Fig. 11 illustrates a schematic block diagram of an example circuit arrangement according to embodiments disclosed herein;
Fig. 12 illustrates a schematic block diagram of an example method for driving power transistors in a parallel arrangement; and
Fig. 13 illustrates a sixth schematic timing diagram according to embodiments disclosed herein.

### DETAILED DESCRIPTION

According to a first aspect, a gate drive circuit is disclosed. The gate drive circuit is configured for driving at least a first and a second power transistor between switching states, wherein the first and second power transistor are arranged in parallel between a first load node and a second load node. The gate drive circuit comprises a control signal input node configured to receive a common control signal, a first temperature input node configured to receive a first temperature signal indicative of a temperature of the first power transistor, a second temperature input node configured to receive a second temperature signal indicative of a temperature of the second power transistor, a delay determination unit configured to determine a delay signal comprising at least one of a turn-on delay value and a turn-off delay value based on a comparison of the temperature of the first power transistor and the temperature of the second power transistor, a drive signal generation unit configured to generate a first drive signal for driving the first power transistor and a second drive signal for driving the second power transistor based on the common control signal and the delay signal such that a time difference between a turn-on timing of the first drive signal and a turn-on timing of the second drive signal corresponds to the turn-on delay value and/or such that a time difference between a turn-off timing of the first drive signal and a turn-off timing of the second drive signal corresponds to the turn-off delay value, a first driver stage configured to provide the first drive signal at a first driving node configured to be coupled to a control node of the first power transistor, and a second driver stage configured to provide the second drive signal at a second driving node configured to be coupled to a control node of the second power transistor.

This gate drive circuit has the advantage that temperature differences between the two parallel operated power transistors can be equilibrated, such that the two power transistors have an essentially identical temperature during operation. This is achieved without generating additional losses, which would decrease an efficiency of the transistor arrangement, but instead the unavoidable turn-on and/or turn-off losses are distributed between the two power transistors such that the temperatures equilibrate. Advantageously this is achieved independent of an origin of a temperature difference (e.g., parameter spread between the power transistors, circuit topology, or cooling efficiency, just to name a few). By equalizing the temperatures, temperature-dependent aging effects are also equalized for the two power transistors, so that they age more equally. This can prolong the operating life of the arrangement of the two power transistors. In addition, a continuous output power of the two parallel power transistors may be higher than when the temperatures are not equalized, since in such case one of the power transistors may reach an upper temperature threshold, so that the power output must be throttled. A further advantage is that temperature changes of the power transistors are slow (e.g., on the order of seconds) compared to the switching operation (e.g., on the order of tens of kHz), such that the control cycle for temperature equilibration is essentially decoupled from the switching operation, such that the delay determination unit does not need to be synchronized and can operate at a low speed, simplifying the implementation.

The delay determination unit and/or the drive signal generation unit can be implemented in hardware and/or software. In a hardware implementation, the respective unit can be embodied, for example, as a computer, as a microprocessor, as an application specific circuit (ASIC), as a field-programmable gate array (FPGA), as a programmable logic controller (PLC) or the like. In a software implementation, the respective unit can be embodied as a computer program product, as a function, as a routine, as an algorithm, as part of a program code, as an executable object, or the like. Additionally, the respective unit may be implemented based on or may include an artificial intelligence model, such as a trained neural network, e.g. a convolutional neural network or a recurrent neural network, or the like.

According to one or more embodiments, the delay determination unit is configured for determining the turn-on delay value and/or the turn-off delay value based on a temperature difference between the temperature of the first power transistor and the second power transistor such that the power transistor having the higher temperature is turned on after and/or turned off before the power transistor having the lower temperature.

According to one or more embodiments, the turn-on timing of at least one of the first drive signal and the second drive signal is synchronized to a turn-on timing of the common control signal, and the turn-off timing of at least one of the first drive signal and the second drive signal is synchronized to a turn-off timing of the common control signal.

In further embodiments, the delay signal only comprises a turn-on delay value. This means that no turn-off delay value is determined, and consequently the turn-off of the first and second power transistors is essentially synchronous (except for propagation delays that may be present) with the common control signal. This may have the advantage that the earliest turn-on of one of the power transistors is essentially synchronous with the common control signal, such that an active time (the time during which at least one of the power transistors is in on-state) corresponds to the that of the common control signal.

According to one or more embodiments, the turn-on delay value and/or the turn-off delay value is proportional to a temperature difference between the first power transistor and the second power transistor.

Here, "proportional to" is not to be construed to be limited to a mathematically exact linear proportionality, but to include other functions that can be used to describe a relationship between a first and a second value such that the second value increases when the first value increases. This may also include step functions. In other words, the turn-on delay value and/or the turn-off delay value increases when the temperature difference increases.

According to one or more embodiments, the turn-on delay value and/or the turn-off delay value are at most 1%, preferably at most 0.1%, of a reference time period of the common control signal.

For example, the common control signal may be a pulse width modulation (PWM) signal having a frequency "f" and a duty cycle "d". The reference time period may be given by a cycle period (e.g., T = 1/f), an "on time period" of the common control signal, which may be construed as the duty cycle divided by the frequency (e.g., Ton = T*d = d/f), or an "off time period" (e.g., Toff = 1-Ton). In some embodiments, the reference time period may have a fixed value, for example in application circuits where the switching frequency of the common control signal is set to a fixed value. In some embodiments, when the switching frequency is variable, e.g., adjustable based on a load condition or the like, the reference time period may have a variable value that varies in accordance with the switching frequency, for example. However, even when the switching frequency is variable, the reference time period may have fixed value, which may be set, for example, based on a maximum or a minimum switching frequency that is allowed in the respective application circuit (e.g., the application specific operating boundaries). It is noted, since a turn-off delay value may extend the duty cycle, one consideration for setting an upper limit of the turn-off delay value may be the implementation of a dead time when the power transistor is part of a half bridge arrangement. Here, the dead time is implemented to avoid a cross conduction or "shoot through" of the half bridge arrangement.

For example, an upper limit of the turn-on delay value and/or the turn-off delay value may be in a range of single digit nanoseconds (ns) up to a few tens of nanoseconds (e.g., 1 ns - 50 ns, preferably 1 ns - 20 ns).

According to one or more embodiments, a switching frequency of the common control signal is at least 10 kHz, preferably 50 kHz, and up to 1 MHz.

According to one or more embodiments, the gate drive circuit further comprises an analog-to-digital converter configured for converting the received temperature signals into a digital temperature signal.

This allows processing the temperature signal by a digital logic. In embodiments, the delay determination unit is implemented as a digital circuit. In further embodiments, the signal generation unit is implemented by a digital circuit.

According to one or more embodiments, the delay determination unit is configured to determine a first turn-on delay value corresponding to the first power transistor and a second turn-on delay value corresponding to the second power transistor, and/or a first turn-off delay value corresponding to the first power transistor and a second turn-off delay value corresponding to the second power transistor, wherein each respective delay value can have a zero value or a positive value.

According to one or more embodiments, at least one of the first turn-on delay value and the second turn-on delay value has a zero value and at least one of the first turn-off delay value and the second turn-off delay value has a zero value.

This means that one of the first or the second power transistor is controlled to turn on and to turn off synchronous with the common control signal.

According to one or more embodiments, the first driver stage and the second driver stage are integrated in a common package.

In this embodiment the gate drive circuit is provided as a single discrete device.

According to one or more embodiments, the first driver stage and the second driver stage are integrated on a common chip die.

The common chip die may further include analog and/or digital logic, for example the delay determination unit and/or the drive signal generation unit.

According to one or more embodiments, the gate drive circuit further comprises a first voltage domain and a second voltage domain that is electrically isolated from the first voltage domain, and a signal transmission circuit configured for transmitting a signal from the first voltage domain to the second voltage domain, wherein the control signal input node is arranged in the first voltage domain, and the first temperature input node, the second temperature input node, the delay determination unit, the drive signal generation unit, the first driver stage and the second driver stage are arranged in the second voltage domain.

This has the advantage that neither the temperature signals nor the delay signal need to be transmitted from the second voltage domain to the first voltage domain, thus decreasing complexity and cost of the gate drive circuit.

According to one or more embodiments, the gate drive circuit comprises a primary driver unit corresponding to the first power transistor and a secondary driver unit corresponding to the second power transistor, each of the primary driver unit and the secondary driver unit comprising a respective control signal input node and a respective driver stage configured to provide a respective drive signal at a respective driving node, and the primary driver unit and the secondary driver unit each comprising a respective communication interface configured for communication with the respective other driver unit, and wherein the delay determination unit is arranged in the primary driver unit.

In this embodiment the primary driver unit and the secondary driver unit may be provided in separate packages, including separate discrete packages.

According to one or more embodiments, the primary driver unit comprises the first temperature input node and the second temperature input node, the communication interface of the primary driver unit is configured for sending the delay signal to the communication interface of the secondary driver unit, and each of the primary driver unit and the secondary driver unit comprises a respective drive signal generation unit configured to generate the respective drive signal.

In this embodiment, the logic used to determine the delay signal for temperature equilibration is fully arranged in the primary driver unit. The secondary driver unit may therefore be implemented in a relatively simple manner.

According to one or more embodiments, the primary driver unit comprises the first temperature input node, the secondary driver unit comprises the second temperature input node, the communication interface of the secondary driver unit is configured for sending the second temperature signal to the communication interface of the primary driver unit, the communication interface of the primary driver unit is configured for sending the delay signal to the communication interface of the secondary driver unit, and each of the primary driver unit and the secondary driver unit comprises a respective drive signal generation unit configured to generate the respective drive signal.

According to one or more embodiments, the primary driver unit and the secondary driver unit are integrated in different packages.

According to one or more embodiments, the delay determination unit is configured to determine the turn-on delay value corresponding to the power transistor having the higher temperature to be 100% of an on-time period of the common control signal, and wherein the drive signal generation unit is configured to generate the drive signal of the corresponding power transistor based on the common control signal and the delay signal such that the corresponding drive signal is maintained at a low value during at least one switching cycle of the common control signal.

Here, the "low value" of the drive signal corresponds to an off-state of the power transistor. Hence, in this embodiment, the power transistor having the higher temperature is maintained in the off-state for at least one switching cycle. Thus, during this switching cycle, no losses are generated in the power transistor, while the other power transistor is operated according to the common control signal. Consequently, the power transistor with the higher temperature is allowed to cool while the other power transistor is heated more, effectively equilibrating the temperatures. It is noted that the power transistor that is operated according to the common control signal may be operated in an overcurrent state during the skipped switching cycle, since it has to provide the complete load current. For example, the overcurrent may be approximately two times the normal current. However, since this current has to be provided only during a short time (e.g., the on-time period of one switching cycle), this may not negatively impact a lifetime of the power transistor.

According to one or more embodiments, the drive signal generation unit is configured to generate the corresponding drive signal based on a skipping value, wherein the skipping value defines a number of switching cycles to be skipped in a predetermined number of switching cycles, such that the corresponding drive signal is maintained at a low value in accordance with the skipping value.

For example, the skipping value may be provided as a number N/M, where N indicates the number of switching cycles to be skipped and M indicates the predetermined number of switching cycles. For example, the skipping value may be a number in a range of 1/100 (N=1, M=100) up to 99/100 (N=99, M=100). Here, 1/100 may define that 1 switching cycle in 100 switching cycles is to be skipped, and 99/100 may define that 99 of 100 switching cycles are to be skipped. It is noted that M may have a different value than 100. For example, the skipping value may be 1/2 (N=1, M=2), indicating that every other switching cycle is to be skipped. It is noted that skipping values defining the same fraction but with different numbers (e.g., 1/2, 2/4, 10/20, etc.) may have the same impact and may be considered as equivalent.

It is noted that the skipping value may be a fixed value or may be an adjustable value. For example, the skipping value may be adjusted based on a temperature difference between the two power transistors, wherein the skipping value is set to higher values in case of higher temperature difference (e.g., the skipping number is proportional to the temperature difference).

According to one or more embodiments, the delay determination unit is further configured to determine the skipping value based on the comparison of the temperature of the first power transistor and the temperature of the second power transistor.

According to one or more embodiments, the gate drive circuit further comprises a third temperature input node configured to receive a third temperature signal indicative of a temperature of a third power transistor arranged between the first load node and the second load node in parallel to the first and second power transistor, and wherein the delay determination unit is configured to determine the delay signal to further comprise at least one of a further turn-on delay value and a further turn-off delay value based on a comparison of the temperature of the first power transistor and the temperature of the third power transistor, the drive signal generation unit is configured to generate a third drive signal for driving the third power transistor based on the common control signal and the delay signal such that a time difference between a turn-on timing of the first drive signal and a turn-on timing of the third drive signal corresponds to the further turn-on delay value and/or such that a time difference between a turn-off timing of the first drive signal and a turn-off timing of the third drive signal corresponds to the further turn-off delay value, and further comprising a third driver stage configured to provide the third drive signal at a third driving node configured to be coupled to a control node of the third power transistor.

According to this embodiment, the gate drive circuit may be extended to a larger number of parallel power transistors that are intended to be operated by the common control signal. It is noted that the gate drive circuit may be extended to more than corresponding three driving stages.

In further embodiments, the delay determination unit may be configured for determining an intermediate temperature based on the first, the second and the third temperature signal, and determine the delay signal based on a temperature difference between the respective temperature of the respective power transistor and the intermediate temperature.

In further embodiments, the gate drive circuit is configured for operating the temperature sensors to obtain the temperature signals. For example, the gate drive circuit may supply the temperature sensors with power for their operation. In some embodiments, the gate drive circuit may apply a respective voltage to the respective temperature input node and determine the respective temperature signal based on a current flowing through the respective temperature input node.

In further embodiments, the first and second temperature input node are provided as a common node or terminal. In this case, the first and second temperature signals may be received having different signal properties, such as a frequency or the like. Also, the temperature sensors may be individually addressable by the gate drive circuit, such that the temperature signals may be polled in different time slots. In one or more embodiments, the temperature sensors may be addressed based on a well-known communication protocol, such as I2C (inter-integrated circuit), SPI (serial peripheral interface), UART (universal asynchronous receiver transmitter) or CAN (controller are network).

According to a second aspect, a method for determining drive signals for driving of a first and a second power transistor between switching states, wherein the first and second power transistor are arranged in parallel between a first load node and a second load node, is provided. The method comprises determining a temperature of the first power transistor and a temperature of the second power transistor, determining a turn-on delay value and/or a turn-off delay value based on a comparison of the temperature of the first power transistor and the temperature of the second power transistor, and determining a first drive signal corresponding to the first power transistor and a second drive signal corresponding to the second power transistor based on a common control signal such that a time difference between a turn-on timing of the first drive signal and a turn-on timing of the second drive signal corresponds to the turn-on delay value and/or a time difference between a turn-off timing of the first drive signal and a turn-off timing of the second drive signal corresponds to the turn-off delay value.

This method has similar advantages as described referring to the gate drive circuit of the first aspect. The embodiments described referring to the gate drive circuit also form embodiments of the method. It is noted that the method may be extended to more than two parallel power transistors. It is noted that the method may include further method steps and/or intervening method steps.

In one or more embodiments the method further includes driving the first and second power transistors according to the first and second drive signals.

According to a third aspect a circuit arrangement is provided. The circuit arrangement includes the gate drive circuit according to the first aspect and further includes a first power transistor coupled between a first load node and a second load node and coupled to the first driving node, a second power transistor coupled between the first load node and the second load node and coupled to the second driving node, a first temperature sensor configured to measure a temperature of the first power transistor and coupled to the first temperature input node, and a second temperature sensor configured to measure a temperature of the second power transistor and coupled to the second temperature input node.

The circuit arrangement may be configured to control a current flow between the first and second load node by switching the first and second power transistor between switching states based on the common control signal.

The temperature sensors may be implemented in any suitable manner that provides for a sufficiently accurate temperature signal corresponding to the respective power transistor. What may be relevant in this regard is to provide for a good thermal coupling between the respective temperature sensor and the respective power transistor, while reducing a thermal coupling to the environment or other heat dissipating elements, in particular other power transistors, in the vicinity. For example, a thermal coupling to the respective power transistor should be at least two times higher than a thermal coupling to the environment. For example, the temperature sensors may be included in the respective power transistor (e.g., a diode integrated in the same chip die as the transistor cells), or included in a common package with the respective power transistor (e.g., a temperature sensitive sensing element, such as an NTC (negative temperature coefficient) or PTC (positive temperature element), integrated in a common package with the power transistor die), or arranged external to a package of the respective power transistor. In addition, the temperature sensors may be implemented to directly or indirectly measure a junction temperature of the respective power transistor, for example by obtaining a measure of an on-state resistance (e.g., referred to as RDSon, meaning a drain-source resistance in case of MOSFETs or the like) or similar.

In embodiments the gate drive circuit is configured for operating the temperature sensors to obtain the temperature signals. For example, the gate drive circuit may supply the temperature sensors with power for their operation. In some embodiments, the gate drive circuit applies a respective voltage to the respective temperature input node and determines the respective temperature signal based on a current flowing through the respective temperature input node.

According to one or more embodiments of the circuit arrangement, the first power transistor and the second power transistor are made from a wide bandgap material, such as silicon carbide or gallium nitride.

According to one or more embodiments of the circuit arrangement, it further comprises a controller coupled to the control input node and configured to provide the common control signal.

According to a fourth aspect, a primary gate drive circuit is provided. The primary gate drive circuit is configured for driving a first power transistor between switching states and is specifically adapted to be used in combination with at least one specifically adapted secondary gate drive circuit that is configured for driving at least one second power transistor between switching states, wherein the first and at least one second power transistor are arranged in parallel between a first load node and a second load node. The primary gate drive circuit comprises a control signal input node configured to receive a common control signal, a first temperature input node configured to receive a first temperature signal indicative of a temperature of the first power transistor, at least one second temperature input node configured to receive a respective second temperature signal indicative of a temperature of the at least one second power transistor, a delay determination unit configured to determine a respective turn-on delay value corresponding to each respective one of the first power transistor and the at least one second power transistor, and/or a respective turn-off delay value corresponding to each respective one of the first power transistor and the at least one second power transistor, based on a comparison of the temperature of the first power transistor and the respective temperature of the at least one second power transistor, a communication interface configured to be coupled to a corresponding communication interface of the at least one secondary gate drive circuit and to transmit the respective turn-on delay value and/or the respective turn-off delay value to the at least one secondary gate drive circuit; a drive signal generation unit configured to generate a drive signal for driving the first power transistor based on the common control signal and the turn-on delay value and/or the turn-off delay value corresponding to the first power transistor such that a time difference between a turn-on timing of the common control signal and a turn-on timing of the drive signal corresponds to the turn-on delay value corresponding to the first power transistor and/or such that a time difference between a turn-off timing of the common control signal and a turn-off timing of the drive signal corresponds to the turn-off delay value corresponding to the first power transistor, and a driver stage configured to provide the drive signal at a driving node configured to be coupled to a control node of the first power transistor.

According to a fifth aspect a secondary gate drive circuit is provided. The secondary gate drive circuit is configured for driving a second power transistor between switching states and is specifically adapted to be used in combination with a specifically adapted primary gate drive circuit that is configured for driving a first power transistor between switching states, wherein the first and second power transistor are arranged in parallel between a first load node and a second load node. The secondary gate drive circuit comprises a control signal input node configured to receive a common control signal, a communication interface configured to be coupled to a communication interface of the primary gate drive circuit and to receive a turn-on delay value and/or a turn-off delay value, a drive signal generation unit configured to generate a drive signal for driving the second power transistor based on the common control signal and the turn-on delay value and/or the turn-off delay value such that a time difference between a turn-on timing of the common control signal and a turn-on timing of the drive signal corresponds to the turn-on delay value and/or such that a time difference between a turn-off timing of the common control signal and a turn-off timing of the drive signal corresponds to the turn-off delay value, and a driver stage configured to provide the drive signal at a driving node configured to be coupled to a control node of the second power transistor.

The primary gate drive circuit of the fourth aspect and the secondary gate drive circuit of the fifth aspect form a set of devices that are specifically designed to be used in together in a system for driving parallel power transistors based on a common control signal.

The primary gate drive circuit may be referred to as a "master driver" and any secondary gate drive circuits may be referred to as "slave drivers". This system partitioning has the advantage that the slave drivers may be implemented in a relatively simple manner, where essentially only a communication interface as well as logic for processing and applying the received delay values are required in addition to features conventional for gate drivers. Only the master driver may require additional nodes to receive the plurality of temperature signals and may require the delay determination unit.

The communication interface may be provided by any means that allows to transmit the delay signal or the information contained in the delay signal from the primary gate drive circuit to the secondary gate drive circuit. In one example, the delay signal may be provided as an analog voltage, wherein a voltage level corresponds to the turn-on delay value and/or the turn-off delay value. In a further example, the delay signal may be provided by a voltage signal having a variable frequency, wherein the frequency corresponds to the turn-on delay value and/or the turn-off delay value. These examples may also be combined. In these examples, a single wire connection between the communication interfaces may be sufficient. However, the communication interfaces may also be configured to implement and communicate according to one or more well-known protocols, such as I2C (inter-integrated circuit), SPI (serial peripheral interface), UART (universal asynchronous receiver transmitter) or CAN (controller are network).

According to a sixth aspect, a computer program product is provided. The computer program product includes instructions that, when executed by a device, cause the device to perform the method according to the second aspect.

The computer program product may be provided as a downloadable file on a server that is accessible via a corresponding network and/or as a computer readable medium that stores the instructions in a computer readable format, such as a binary code or the like. The computer readable medium may be provided in form of a non-volatile memory, for example.

In the following, the aspects and embodiments provided herein are described in more detail referring to the enclosed figures.

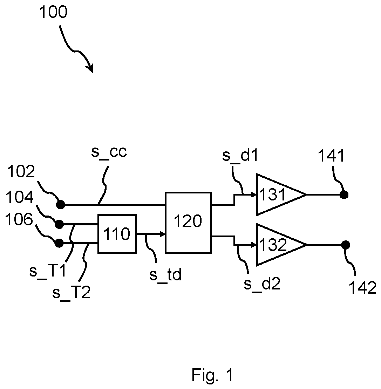

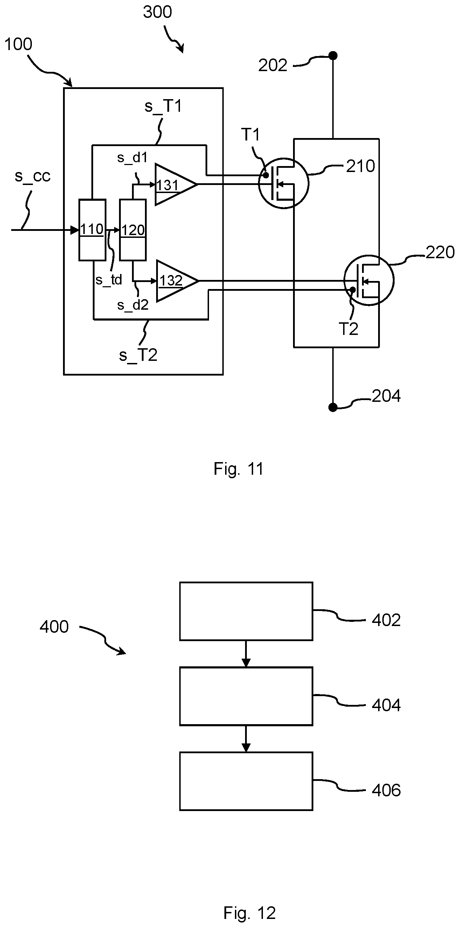

Fig. 1 illustrates a schematic block diagram of a first example implementation of a gate drive circuit 100. The gate drive circuit 100 includes a control signal input node 102 for receiving a common control signal s_cc, a first temperature input node 104 for receiving a first temperature signal s_T1 and a second temperature input node 106 for receiving a second temperature signal s_T2. The first temperature signal s_T1 may be indicative of the temperature of a first power transistor 210 (see Fig. 11) and the second temperature signal s_T2 may be indicative of the temperature of a second power transistor 220 (see Fig. 11).

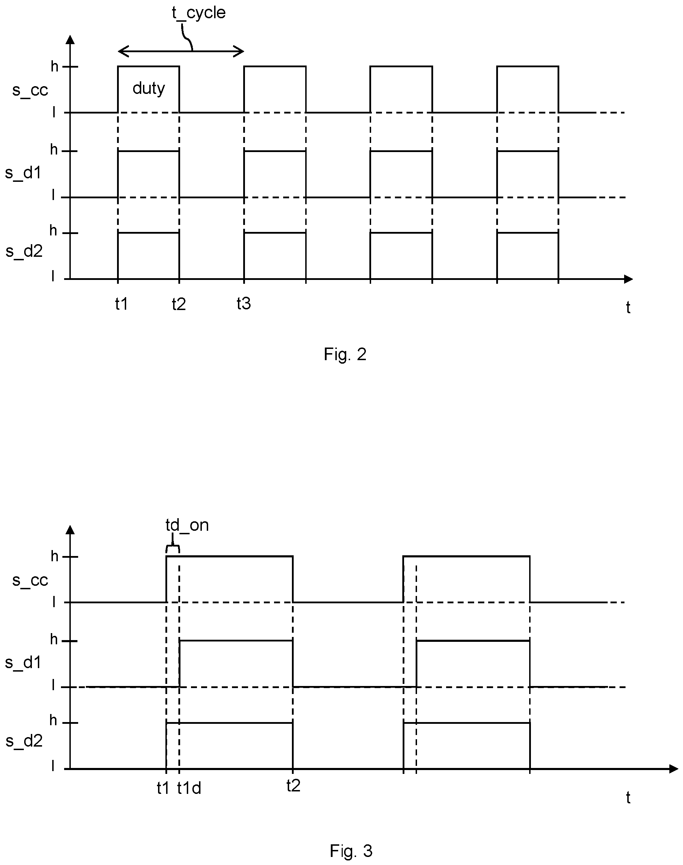

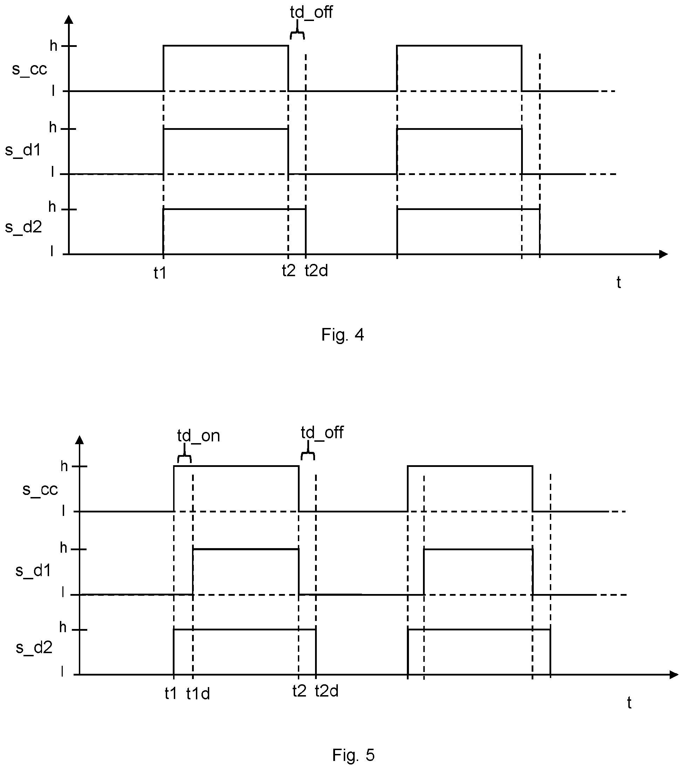

The gate drive circuit 100 further includes a delay determination unit 110 configured to determine a delay signal s_td. The delay signal s_td comprises at least one of a turn-on delay value td_on (see Fig. 3 or 5) and a turn-off delay value td_off (see Fig. 4 or 5) based on a comparison of the temperature of the first power transistor 210 and the temperature of the second power transistor 220. For example, the delay signal comprises a respective turn-on delay value and/or turn-off delay value corresponding to the first and second power transistor. For example, the delay determination unit 110 determines the delay signal s_td based on a difference between the temperatures of the power transistors such that the power transistor with the higher temperature has a larger turn-on delay value and/or a larger turn-off delay value than the power transistor with the lower temperature. Preferably, for the case of two parallel power transistors, the power transistor with the lower temperature has a zero value as the turn-on delay value and/or turn-off delay value and the power transistor with the higher temperature has a positive value as the turn-on delay value and/or turn-off delay value. This will effectively cause that the power transistor with the higher temperature is switched on after and/or switched off before the power transistor with the lower temperature, such that most of the switching losses are generated in the power transistor with the lower temperature. In consequence, the temperature of the power transistor with the lower temperature increases more than the temperature of the power transistor with the higher temperature, and thus the temperature difference is reduced and the temperatures are equalized with each switching cycle.

The gate drive circuit 100 further includes a drive signal generation unit 120 configured to generate a first drive signal s_d1 for driving the first power transistor 210 and a second drive signal s_d2 for driving the second power transistor 220 based on the common control signal s_cc and the delay signal s_td. The drive signals are determined such that a time difference between a turn-on timing of the first drive signal s_d1 and a turn-on timing of the second drive signal s_d2 corresponds to the turn-on delay value td_on and/or such that a time difference between a turn-off timing of the first drive signal s_d1 and a turn-off timing of the second drive signal s_d2 corresponds to the turn-off delay value td_off. The first drive signal s_d1 is provided to a first driver stage 131 of the gate drive circuit 100, which is configured to provide the first drive signal s_d1 at a first driving node 141 that is configured to be coupled to a control node of the first power transistor 210. The second drive signal s_d2 is provided to a second driver stage 132 of the gate drive circuit, which is configured to provide the second drive signal s_d2 at a second driving node 142 that is configured to be coupled to a control node of the second power transistor 220. The first and second driver stage 131, 132 are provided as buffers in this example that may source or sink a current based on the respective drive signal s_d1, s_d2, for example to charge or discharge a gate of the respective power transistor 210, 220. For example, the delay signal s_td may be represented by an analog voltage signal, wherein a positive voltage indicates a positive turn-on delay value and/or turn-off delay value. Just by way of example, the drive signal generation unit 120 may be implemented using a comparator that receives the delay signal s_td at its inverting input and receives a sawtooth voltage signal at its non-inverting input. In this example, the output of the comparator will be low as long as the sawtooth voltage value is lower than the delay signal value, and switches to high as soon the sawtooth voltage value increases over the delay signal value. The sawtooth voltage may be reset in each switching cycle and start at a low value (e.g., zero value) synchronous with a rising flank and/or falling flank of the common control signal. Therefore, the output of the comparator may be used as a timer to indicate when the drive signal is to be switched from low to high (in case of a turn-on delay value) or from high to low (in case of a turn-off delay value). It is noted that this is just one example that should not be construed as limiting.

Fig. 2 to 5 each illustrate a schematic timing diagram according to embodiments disclosed herein. Each timing diagram includes individual signal traces for the common control signal s_cc, the first drive signal s_d1 and the second drive signal s_d2. In these examples, the signals are indicated as binary signals having a high "h" and a low "I" value. In addition, the common control signal s_cc is indicated by way of example as a pulse width modulation signal having a certain frequency 1/t_cycle (see Fig. 2) and duty cycle "duty" (see Fig. 2).

The duty cycle "duty" may be equated as the fraction of the cycle time (t_cycle = t3-t1) during which the signal has a high "h" value (i.e., duty = (t2-t1)/(t3-t1)).

Fig. 2 shows an example in which both the first drive signal s_d1 and the second drive signal s_d2 are synchronous with the common control signal s_cc. This may be the case when the temperature difference between the first and second power transistors is essentially zero or below a threshold value.

Fig. 3 shows an example in which the delay signal s_td is determined to include a turn-on delay value td_on corresponding to the first power transistor 210. This has the effect that the drive signal generation unit 120 generates the second drive signal s_d2 essentially synchronous with the common control signal s_cc, and generates the first drive signal s_d1 such that a turn-on timing is delayed by the time delay td_on (note that the corresponding reference numerals are only indicated in the first of two switching cycles shown in the diagram).

Fig. 4 shows an example in which the delay signal s_td is determined to include a turn-off delay value td_off corresponding to the second power transistor 220. This has the effect that the drive signal generation unit 120 generates the first drive signal s_d1 essentially synchronous with the common control signal s_cc, and generates the second drive signal s_d2 such that a turn-off timing is delayed by the time delay td_off (note that the corresponding reference numerals are only indicated in the first of two switching cycles shown in the diagram).

Fig. 5 shows an example in which the delay signal s_td is determined to include a turn-on delay value td_on corresponding to the first power transistor 210 and a turn-off delay value td_off corresponding to the second power transistor 220. This has the effect that the drive signal generation unit 120 generates the first drive signal s_d1 such that a turn-on is delayed by the turn-on delay value td_on and a turn-off is essentially synchronous with the common control signal s_cc, while the second drive signal s_d2 is generated such that a turn-on timing is essentially synchronous with the common control signal s_cc and a turn-off timing is delayed by the time delay td_off (note that the corresponding reference numerals are only indicated in the first of two switching cycles shown in the diagram).

All examples shown in Fig. 3-5 may have the effect that the temperature of the second power transistor 220 will increase more than the temperature of the first power transistor 210, because switching losses (turn-on and/or turn-off switching losses) will mostly be generated in the second power transistor 220. Thus, the examples provided may be used when the temperature of the second power transistor 220 is lower than that the temperature of the first power transistor 210 to equilibrate the temperatures. It is noted that diagrams are not drawn to scale, in particular the time delays as indicated are shown in an exaggerated manner for a clear visibility. In practice, the time delays that may be determined may be limited to a few percent of a duty cycle, for example. This may allow to control in which of the power transistors the switching losses occur mostly, and at the same time an average value (averaged across one switching cycle, for example) of a total load current between the first and second load nodes 202, 204 (see Fig. 11) is essentially identical to a case when no time delays are implemented between the drive signals.

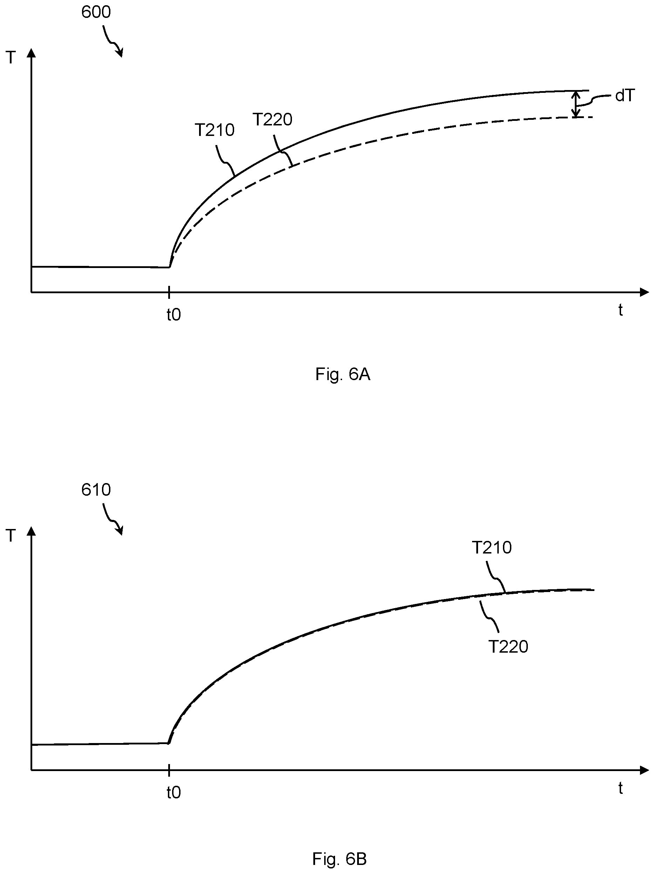

Fig. 6A and 6B each illustrate a schematic diagram 600, 610 including a respective temperature curve T210, T220 for two power transistors when operated in a parallel arrangement according to embodiments disclosed herein. Fig. 6A shows an example of how a first temperature T210 of a first power transistor 210 and a second temperature T220 of a second power transistor 220 may develop when the two power transistors 210, 220 have slightly different parameters, such as different threshold voltage and/or different turn-on resistance, or the like, and are switched essentially synchronously using a common control signal. In such case, the switching and/or conduction losses may mostly accumulate in one of the power transistors 210, 220, leading to an unequal temperature, as is indicated by the temperature difference dT. In this example, the two transistors 210, 220 are at a common temperature (e.g., ambient temperature), when operating them using the common drive signal is started at time t0. The temperature of both power transistors 210, 220 increases, but the one generating more losses heats up faster and to a higher equilibrium temperature compared with the other one. This temperature difference may negatively impact the live of the one power transistor having the higher temperature, which may age faster than the other one, and may fail earlier. In addition, a power limit of the parallel arrangement may be hit earlier, such that an output power has to be reduced in order to keep the power transistors below a predefined maximum temperature. To avoid such negative effects, the power transistors 210, 220 may be operated by the gate drive circuit 100 as explained referring to

Fig. 1, for example. This will have the effect that the temperatures of the two power transistors 210, 220 are effectively equalized, as is shown in the diagram 610 of Fig. 6B. In this case, even though the two power transistors 210, 220 have different parameters, their temperature T210, T220 is essentially identical.

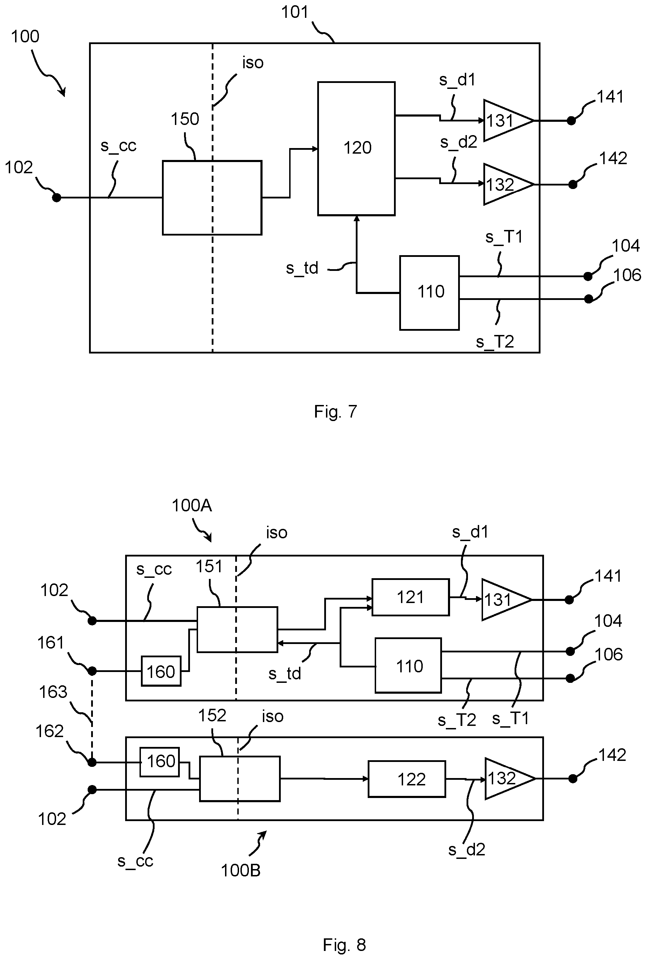

Fig. 7 illustrates a schematic block diagram of a second example implementation of a gate drive circuit 100 in accordance with embodiments disclosed herein. The gate drive circuit 100 may have all elements with respective functionality as described referring to Fig. 1. In addition, the gate drive circuit 100 is enclosed in a housing 101 from which the control signal input node 102, the first temperature input node 104, the second temperature input node 106, the first drive node 141 and the second drive node 142 extend as external terminals. It is noted that the gate drive circuit 100 may have more terminals than shown here, such as power supply terminals and further signaling terminals, e.g. fault, ready, etc. terminals, which are omitted for clarity.

In this example, the gate drive circuit 100 is configured as an isolated drive circuit that includes an isolation barrier iso between an input side (e.g., a low voltage domain) and an output side (e.g., a high voltage domain) and may be used for driving high side switches. In order to transmit the common control signal s_cc from the low voltage domain across the isolation barrier iso to the drive signal generation unit 120 arranged in the high voltage domain a circuit 150 is provided. The circuit 150 may be implemented, for example, as a level-shift circuit, an isolation transformer, an optocoupler, or a capacitively coupled device.

In this example, the temperature input nodes 104, 106 and the delay determination unit 110 are arranged in the high voltage domain. This has the advantage that neither the temperature signals s_T1, s_T2, nor the delay signal s_td, nor the drive signals s_d1, s_d2 need to be transferred across the isolation barrier iso, which keeps the gate drive circuit 100 simple.

Fig. 8 illustrates a schematic block diagram of a third example implementation of a gate drive circuit in accordance with embodiments disclosed herein. The example shown here includes separate gate drive circuits 100A, 100B, each of which is configured for driving a respective power transistor between switching states based on a control signal. The two separate devices 110A, 110B are specifically adapted to be used in combination for driving parallel power transistors based on a common control signal s_cc.

The primary gate drive circuit 100A may have all features of the gate drive circuit described referring to Fig. 7 except that it only has the first driver stage 131 and first drive output node 141. In addition, it comprises a communication interface 160 coupled to a first communication node 161. The communication interface 160 is configured for transmitting signals, for example the delay signal s_td, via the communication node 161 to other communication interfaces. In this example, the communication interface 160 and the communication node 161 are arranged in the low voltage domain, but they may also be provided in the high voltage domain. Further, the circuit 151 is configured for communicating signals across the isolation barrier in both directions, i.e., from the high side to the low side and vice versa.

The secondary gate drive circuit 100B may have a simpler configuration. In this example, the secondary gate drive circuit 100B is also configured as an isolated device having an isolation barrier iso separating the low voltage domain from the high voltage domain. It includes, in the low voltage domain, a control signal input node 102, a communication node 162 and a communication interface 160 coupled to the communication node 162. The communication interface 160 is configured for receiving signals from other communication interfaces via the communication node 162. In this example, the communication interface 160 and the communication node 162 are arranged in the low voltage domain, but they may also be provided in the high voltage domain, corresponding to the implementation of the primary gate drive circuit 100A. In other words, the communication interfaces 160 in the primary and secondary gate drive circuits 100A, 100B are preferably arranged in the same voltage domain, as this avoids the need for additional isolation. The circuit 152 is configured for transferring signals received at the low voltage domain across the isolation barrier iso to the high voltage domain. In the high voltage domain are a drive generation unit 122, a driver stage 132 and a drive output node 142.

For example, when the primary and secondary gate drive circuits 100A, 100B are used together for driving two parallel power transistors based on the common control signal s_cc, the respective control signal input nodes 102 may be connected to a common node (not shown) such that both receive the common control signal s_cc and the two communication nodes 161, 162 are coupled by a signal line 163, which may be provided in any suitable manner. The temperature signals s_T1, s_T2 corresponding to the power transistors are received at the primary gate drive circuit 100A and processed by the delay determination unit 110, which determines the delay signal s_td as described referring to Fig. 1-5, for example. The delay signal s_td is used by the drive signal generation unit 121 of the primary gate drive circuit 100A to generate the first drive signal s_d1. In addition, the delay signal s_td is transferred across the isolation barrier iso by circuit 151 and to the communication interface 160, which transmits the signal via the communication node 161 and signal line 163 to communication node 162, such that the signal is received by the communication interface 160 of the secondary gate drive circuit 100B. From the communication interface 160 the delay signal s_td is transferred across the isolation barrier iso by circuit 152 and provided to drive signal generation unit 122 of the secondary gate drive circuit 100B to generate the second drive signal s_d2. Here, it is noted that transmission of the delay signal s_td is not time critical and does not have to be synchronized or the like with the common control signal s_cc, because temperature changes are slow compared to a switching cycle (e.g., six orders of magnitude slower).

The communication between the communication interfaces 160 may be based on any suitable communication protocol.

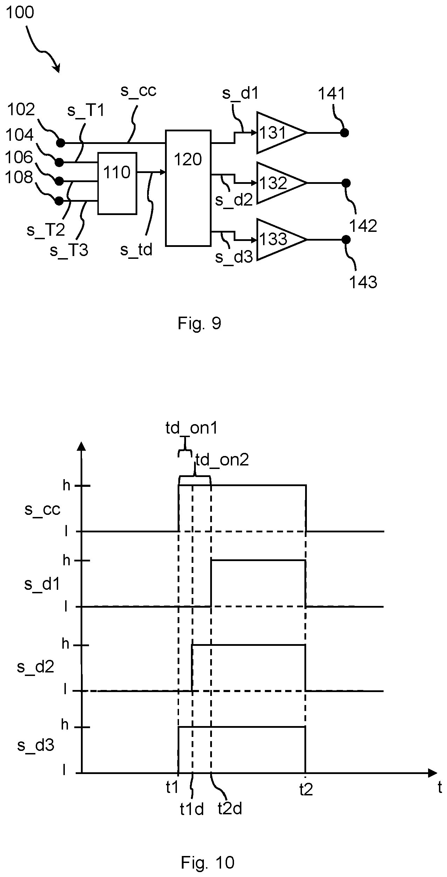

Fig. 9 illustrates a schematic block diagram of a fourth example implementation of a gate drive circuit 100 in accordance with embodiments disclosed herein. In this example, the gate drive circuit 100 is configured for driving three parallel power transistors. The implementation may have similar features as explained referring to any of Fig. 1, 7 or 8, but is extended by one individually controllable driver stage to a total of three driver stages 131, 132, 133. To this end, the gate drive circuit 100 includes three temperature input nodes 104, 106, 108 to receive respective temperature signals s_T1, s_T2, s_T3 corresponding to respective power transistors. The delay determination unit 110 is configured to determine the delay signal s_td in a corresponding manner. For example, the delay determination unit 110 may determine a respective turn-on delay value and/or turn-off delay value corresponding to the respective one of the power transistors based on their temperatures. In other words, the delay signal s_td may comprise three turn-on delay values and/or three turn-off delay values corresponding to the three power transistors. The drive signal generation unit 120 is configured for generating the respective drive signals s_d1, s_d2, s_d3 based on the common control signal s_cc and the delay signal s_td. Fig. 10, which is described in more detail below, provides example drive signals. The drive signals s_d1, s_d2, s_d3 are provided to the respective driver stage 131, 132, 133 which output the drive signal at the respective drive node 141, 142, 143. In this way, the three parallel power transistors driven by the gate drive circuit 100 may be operated with equal temperatures.

As is evident from the examples provided, the gate drive circuit 100 may be configured to be for driving a number N of parallel power transistors, with N>1. For this, the gate drive circuit 100 may have a number of N temperature input nodes, a number of N driver stages, and a number of N drive nodes. The delay determination unit 110 may be configured to determine the delay signal s_td to have a number of N corresponding turn-on delay values and/or turn-off delay values and the drive signal generation 120 unit may be configured to determine a number of N different drive signals based on the delay signal s_td and the common control signal s_cc.

However, this does not necessarily mean that there are N distinct delay values, but some of the different delay values may be of a same value. For example, the delay determination unit may be configured to determine only two different turn-on delay values and/or turn-off delay values: a first turn-on delay value and/or turn-off delay value corresponding to the power transistor with the lowest temperature, and a second turn-on delay value and/or turn-off delay value corresponding to the remaining N-1 power transistors. For example, the first turn-on delay value and/or turn-off delay value corresponds to the power transistor having the lowest temperature among the N power transistors, so to equalize the temperatures the temperature should be increased. To achieve this, the first turn-on delay value may be a zero value and/or the first turn-off delay value may be a positive (non-zero) value, while the second turn-on delay value may be a positive (non-zero) value and/or the second turn-off delay value may be a zero value. Thus, the power transistor with the lowest temperature will turn-on first and/or turn-off last, increasing its temperature compared to the other N-1 power transistors.

Fig. 10 illustrates a schematic timing diagram according to embodiments disclosed herein to illustrate an operation of three parallel power transistors, for example. The timing diagram includes individual signal traces for the common control signal s_cc, the first drive signal s_d1, the second drive signal s_d2 and the third drive signal s_d3. In this example, the signals are indicated as binary signals having a high "h" and a low "I" value.

For example, the third power transistor corresponding to the third drive signal s_d3 may have a lowest temperature, the second power transistor corresponding to the second drive signal s_d2 may have an intermediate temperature and the first power transistor corresponding to the first drive signal s_d1 may have a highest temperature. To equalize the temperatures, the third power transistor should accumulate the most losses (e.g., switching losses, such as turn-on losses), the second power transistor should accumulate an intermediate amount of losses and the first power transistor should accumulate the least losses. In this example, only turn-on delays are employed. Thus, the third drive signal s_d3 is not delayed (i.e., has no turn-on delay compared to the common control signal s_cc), the second drive signal s_d2 is delayed by a first turn-on delay value td_on1 and the first drive signal s_d1 is delayed by a second turn-on delay value td_on2. Therefore, a turn-on sequence of the three power transistors is as follows: the third power transistor turns on at a first time t1, the second power transistor turns on at a second time t1d after the first time t1 and the first power transistor turns on at a third time t2d after the second time t1d. As no turn-off delay values are implemented in this example, all three power transistors turn off essentially synchronous with the common control signal s_cc at time t2.

Fig. 11 illustrates a schematic block diagram of an example circuit arrangement 300 according to embodiments disclosed herein. The example circuit arrangement 300 may be referred to as system 300 in the following. The system 300 includes a gate drive circuit 100, which may be implemented as described referring to any one of the previous figures with corresponding features. Additionally, a load current path including two power transistors 210, 220 is provided. The first power transistor 210 and the second power transistor 220 are connected in parallel between load nodes 202, 204. Here, the power transistors 210, 220 are illustrated as MOSFETs, but this is only an example, and other implementations are also possible. In this example, the power transistors 210, 220 are each connected at their respective drain node to the first load node 202 and at their respective source node to the second load node 204. Each power transistor integrates a respective temperature sensor T1, T2 that provides the respective temperature signal s_T1, s_T2 to the delay determination unit 110. As noted before, the temperature sensors T1, T2 may also be provided external to the power transistors 210, 220.

The system 300 is operated based on the common control signal s_cc, which may be provided from a control unit, such as a microcontroller (not shown), that may be external to the system 300.

The system 300 may be implemented using discrete devices (e.g., discrete power transistors 210, 220 and a common gate drive circuit 100 or separate and individual gate drive circuits 100A, 100B as described referring to Fig. 8, for example), or it may be implemented as a power module where the power transistors 210, 220 are integrate as bare chip dies in a common package (the gate drive circuit 100 may be attached to the package but is external to the package), and/or it may be implemented as an integrated power module where the power transistors 210, 220 and the gate drive circuit 100 are all integrated in a single package.

Fig. 12 illustrates a schematic block diagram of an example method 400 for determining drive signals s_d1, s_d2 (see Fig. 1-5 or 7-11) for driving of a first and a second power transistor 210, 220 (see Fig. 11) between switching states, wherein the first and second power transistor 210, 220 are arranged in parallel between a first load node 202 and a second load node 204. In a first step 402, a temperature of the first power transistor 210 and a temperature of the second power transistor 220 is determined. In a second step 404 a delay signal s_td comprising a turn-on delay value and/or a turn-off delay value based on a comparison of the temperature of the first power transistor 210 and the temperature of the second power transistor 220 is determined. In a third step 406, a first drive signal s_d1 corresponding to the first power transistor 210 and a second drive signal s_d2 corresponding to the second power transistor 220 are determined based on a common control signal s_cc such that a time difference between a turn-on timing of the first drive signal s_d1 and a turn-on timing of the second drive signal s_d2 corresponds to the turn-on delay value and/or a time difference between a turn-off timing of the first drive signal s_d1 and a turn-off timing of the second drive signal s_d2 corresponds to the turn-off delay value.

This method may be performed, for example, by the gate drive circuit 100, 100A, 100B according to one or more implementations described herein.

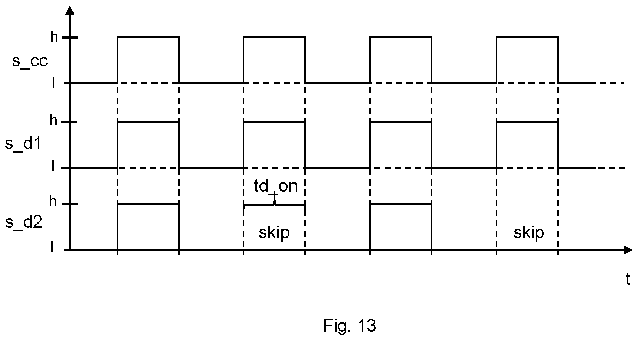

Fig. 13 illustrates a schematic timing diagram according to embodiments disclosed. The timing diagram includes individual signal traces for the common control signal s_cc, the first drive signal s_d1 and the second drive signal s_d2. In this example, the signals are indicated as binary signals having a high "h" and a low "I" value.

In this example, the delay determination unit 110 is configured to determine the turn-on delay value td_on corresponding to the power transistor having the higher temperature (in this example, the power transistor driven according to the second driving signal s_d2) to be 100% of an on-time period of the common control signal s_cc. This effectively causes the drive signal generation unit 120 to generate the corresponding drive signal s_d2 such that there is at least one switching cycle during which the drive signal remains low, as is indicated in Fig. 13 by "skip". In the example of Fig. 13, the drive signal generation 120 unit is configured to generate the drive signal s_d2 based on a skipping value, which is set to 1/2. This means that 1 switching cycle out of 2 switching cycles are skipped. Of course, larger or smaller skipping values are also possible.

In this example, the drive signal generation unit 120 may be implemented in a relatively simple manner, as it does not need to implement a specific delay value to individual switching transitions. For example, the state of an "enable" flag may be checked by the drive signal generation unit 120 before each driving cycle to determine if the drive signal should be in accordance with the common control signal s_cc or if the drive signal should remain low in the following switching cycle. For example, the "enable" flag may be a state of an S-R flip-flop, or the like. Setting the enable flag state may be accomplished by a counter that counts the number switching cycles and compares them with a predefined number, for example. The output of the counter may be a "high" value (e.g., corresponding to a first state of the "enable" flag) until the predefined number is reached, when it turns to a "low" value (corresponding to a second state of the "enable" flag), and then restarts counting. The predefined number may be a fixed number or may be an adjustable number. In this way, the skipping value may be implemented by a counter, for example. It is noted that this is just an example and should not be construed as limiting.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa.

Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

The present disclosure may be further illustrated by the following examples.

An example provides a gate drive circuit configured for driving of at least a first and a second power transistor between switching states, wherein the at least first and second power transistor are arranged in parallel between a first load node and a second load node, the circuit comprising: at least one input node configured for receiving temperature signals indicative of a temperature of the first power transistor and a temperature of the second power transistor, a delay determination unit configured for determining a turn-on delay value and/or a turn-off delay value based on a comparison of the temperature of the first power transistor and the temperature of the second power transistor, and driving stages configured for driving the first power transistor and the second power transistor between switching states in accordance with a common control signal such that a time difference between a turn-on of the first power transistor and a turn-on of the second power transistor corresponds to the turn-on delay value and/or a time difference between a turn-off of the first power transistor and a turn-off of the second power transistor corresponds to the turn-off delay value.

A further example provides a gate drive circuit for driving at least a first and a second power transistor between switching states, wherein the first and second power transistor are arranged in parallel between a first load node and a second load node, the gate drive circuit comprising: a control signal input node configured to receive a common control signal, a first temperature input node configured to receive a first temperature signal indicative of a temperature of the first power transistor, a second temperature input node configured to receive a second temperature signal indicative of a temperature of the second power transistor, a delay determination unit configured to determine a delay signal comprising at least one of a turn-on delay value and a turn-off delay value based on a comparison of the temperature of the first power transistor and the temperature of the second power transistor, a drive signal generation unit configured to generate a first drive signal for driving the first power transistor and a second drive signal for driving the second power transistor based on the common control signal and the delay signal such that a time difference between a turn-on timing of the first drive signal and a turn-on timing of the second drive signal corresponds to the turn-on delay value and/or such that a time difference between a turn-off timing of the first drive signal and a turn-off timing of the second drive signal corresponds to the turn-off delay value, a first driver stage configured to provide the first drive signal at a first driving node configured to be coupled to a control node of the first power transistor, and a second driver stage configured to provide the second drive signal at a second driving node configured to be coupled to a control node of the second power transistor.

In one example the delay determination unit is configured for determining the turn-on delay value and/or the turn-off delay value based on a temperature difference between the temperature of the first power transistor and the second power transistor such that the power transistor having the higher temperature is turned on after and/or turned off before the power transistor having the lower temperature.

In one example the turn-on timing of at least one of the first drive signal and the second drive signal is synchronized to a turn-on timing of the common control signal, and the turn-off timing of at least one of the first drive signal and the second drive signal is synchronized to a turn-off timing of the common control signal.

In one example the turn-on delay value and/or the turn-off delay value is proportional to a temperature difference between the first power transistor and the second power transistor.

In one example the turn-on delay value and/or the turn-off delay value are at most 1%, preferably at most 0.1%, of a reference time period of the common control signal.

In one example the gate drive circuit comprises an analog-to-digital converter configured for converting the received temperature signals into a digital temperature signal.

In one example the delay determination unit is configured to determine a first turn-on delay value corresponding to the first power transistor and a second turn-on delay value corresponding to the second power transistor, and/or a first turn-off delay value corresponding to the first power transistor and a second turn-off delay value corresponding to the second power transistor, wherein each respective delay value can have a zero value or a positive value.

In one example at least one of the first turn-on delay value and the second turn-on delay value has a zero value and at least one of the first turn-off delay value and the second turn-off delay value has a zero value.

In one example the first driver stage and the second driver stage are integrated in a common package.

In one example the first driver stage and the second driver stage are integrated on a common chip die.

In one example the gate drive circuit further comprises a first voltage domain and a second voltage domain that is electrically isolated from the first voltage domain, and a signal transmission circuit configured for transmitting a signal from the first voltage domain to the second voltage domain, wherein the control signal input node is arranged in the first voltage domain, and the first temperature input node, the second temperature input node, the delay determination unit, the drive signal generation unit, the first driver stage and the second driver stage are arranged in the second voltage domain.

In one example the gate drive circuit further comprises a primary driver unit corresponding to the first power transistor and a secondary driver unit corresponding to the second power transistor, each of the primary driver unit and the secondary driver unit comprising a respective control signal input node and a respective driver stage configured to provide a respective drive signal at a respective driving node, and the primary driver unit and the secondary driver unit each comprising a respective communication interface configured for communication with the respective other driver unit, and wherein the delay determination unit is arranged in the primary driver unit.

In one example the primary driver unit comprises the first temperature input node and the second temperature input node, the communication interface of the primary driver unit is configured for sending the delay signal to the communication interface of the secondary driver unit, and each of the primary driver unit and the secondary driver unit comprises a respective drive signal generation unit configured to generate the respective drive signal.

In one example the primary driver unit comprises the first temperature input node, the secondary driver unit comprises the second temperature input node, the communication interface of the secondary driver unit is configured for sending the second temperature signal to the communication interface of the primary driver unit, the communication interface of the primary driver unit is configured for sending the delay signal to the communication interface of the secondary driver unit, and each of the primary driver unit and the secondary driver unit comprises a respective drive signal generation unit configured to generate the respective drive signal.

In one example the primary driver unit and the secondary driver unit are integrated in different packages.

In one example the delay determination unit is configured to determine the turn-on delay value corresponding to the power transistor having the higher temperature to be 100% of an on-time period of the common control signal, and wherein the drive signal generation unit is configured to generate the drive signal of the corresponding power transistor based on the common control signal and the delay signal such that the corresponding drive signal is maintained at a low value during at least one switching cycle of the common control signal.

In one example the drive signal generation unit is configured to generate the corresponding drive signal based on a skipping value, wherein the skipping value defines a number of switching cycles to be skipped in a predetermined number of switching cycles, such that the corresponding drive signal is maintained at a low value in accordance with the skipping value. In one example the delay determination unit is further configured to determine the skipping value based on the comparison of the temperature of the first power transistor and the temperature of the second power transistor.

In one example the gate drive circuit further comprises a third temperature input node configured to receive a third temperature signal indicative of a temperature of a third power transistor arranged between the first load node and the second load node in parallel to the first and second power transistor, and wherein the delay determination unit is configured to determine the delay signal to further comprise at least one of a further turn-on delay value and a further turn-off delay value based on a comparison of the temperature of the first power transistor and the temperature of the third power transistor, the drive signal generation unit is configured to generate a third drive signal for driving the third power transistor based on the common control signal and the delay signal such that a time difference between a turn-on timing of the first drive signal and a turn-on timing of the third drive signal corresponds to the further turn-on delay value and/or such that a time difference between a turn-off timing of the first drive signal and a turn-off timing of the third drive signal corresponds to the further turn-off delay value, and further comprising a third driver stage configured to provide the third drive signal at a third driving node configured to be coupled to a control node of the third power transistor.

An example method for determining drive signals for driving of a first and a second power transistor between switching states, wherein the first and second power transistor are arranged in parallel between a first load node and a second load node, is provided. The method comprises determining a temperature of the first power transistor and a temperature of the second power transistor, determining a turn-on delay value and/or a turn-off delay value based on a comparison of the temperature of the first power transistor and the temperature of the second power transistor, and determining a first drive signal corresponding to the first power transistor and a second drive signal corresponding to the second power transistor based on a common control signal such that a time difference between a turn-on timing of the first drive signal and a turn-on timing of the second drive signal corresponds to the turn-on delay value and/or a time difference between a turn-off timing of the first drive signal and a turn-off timing of the second drive signal corresponds to the turn-off delay value.

An example circuit arrangement is provided, comprising the gate drive circuit of one of the examples described above, a first power transistor coupled between a first load node and a second load node and coupled to the first driving node, a second power transistor coupled between the first load node and the second load node and coupled to the second driving node, a first temperature sensor configured to measure a temperature of the first power transistor and coupled to the first temperature input node, and a second temperature sensor configured to measure a temperature of the second power transistor and coupled to the second temperature input node.

In one example the first power transistor and the second power transistor are made from a wide bandgap material, such as silicon carbide or gallium nitride.

In one example the circuit arrangement further comprises a controller coupled to the control input node and configured to provide the common control signal.

An example provides a primary gate drive circuit that is configured for driving a first power transistor between switching states, the primary gate drive circuit being specifically adapted to be used in combination with at least one secondary gate drive circuit that is configured for driving at least one second power transistor between switching states, wherein the first and at least one second power transistor are arranged in parallel between a first load node and a second load node, the primary gate drive circuit comprising a control signal input node configured to receive a common control signal, a first temperature input node configured to receive a first temperature signal indicative of a temperature of the first power transistor, at least one second temperature input node configured to receive a respective second temperature signal indicative of a temperature of the at least one second power transistor, a delay determination unit configured to determine a respective turn-on delay value corresponding to each respective one of the first power transistor and the at least one second power transistor, and/or a respective turn-off delay value corresponding to each respective one of the first power transistor and the at least one second power transistor, based on a comparison of the temperature of the first power transistor and the respective temperature of the at least one second power transistor, a communication interface configured to be coupled to a corresponding communication interface of the at least one secondary gate drive circuit and to transmit the respective turn-on delay value and/or the respective turn-off delay value to the at least one secondary gate drive circuit; a drive signal generation unit configured to generate a drive signal for driving the first power transistor based on the common control signal and the turn-on delay value and/or the turn-off delay value corresponding to the first power transistor such that a time difference between a turn-on timing of the common control signal and a turn-on timing of the drive signal corresponds to the turn-on delay value corresponding to the first power transistor and/or such that a time difference between a turn-off timing of the common control signal and a turn-off timing of the drive signal corresponds to the turn-off delay value corresponding to the first power transistor, and a driver stage configured to provide the drive signal at a driving node configured to be coupled to a control node of the first power transistor.

An example provides a secondary gate drive circuit that is configured for driving a second power transistor between switching states, the secondary gate drive circuit being specifically adapted to be used in combination with the primary gate drive circuit that is configured for driving a first power transistor between switching states, wherein the first and second power transistor are arranged in parallel between a first load node and a second load node, the secondary gate drive circuit comprising: a control signal input node configured to receive a common control signal, a communication interface configured to be coupled to the communication interface of the primary gate drive circuit and to receive a turn-on delay value and/or a turn-off delay value; a drive signal generation unit configured to generate a drive signal for driving the second power transistor based on the common control signal and the turn-on delay value and/or the turn-off delay value such that a time difference between a turn-on timing of the common control signal and a turn-on timing of the drive signal corresponds to the turn-on delay value and/or such that a time difference between a turn-off timing of the common control signal and a turn-off timing of the drive signal corresponds to the turn-off delay value, and a driver stage configured to provide the drive signal at a driving node configured to be coupled to a control node of the second power transistor.

An example provides a gate drive circuit that is configured for driving of at least a first and a second power transistor between switching states, wherein the at least first and second power transistor are arranged in parallel between a first load node and a second load node, the gate drive circuit comprising: at least one input node configured for receiving temperature signals indicative of a temperature of the first power transistor and a temperature of the second power transistor, a temperature equilibration unit configured for determining which of the at least first and second power transistors has the highest temperature and to generate a corresponding select signal indicative of the power transistor having the highest temperature, a drive signal generation unit configured for generating a first drive signal for driving the first power transistor and a second drive signal for driving the second power transistor based on a common control signal and the select signal, wherein the drive signal corresponding to the one power transistor that is not indicated by the select signal is generated in accordance with the common control and the drive signal corresponding to the other power transistor that is indicated by the select signal is generated such that at least one switching cycle of the common control signal is skipped.

In one example, the drive signal generation unit is configured to generate the drive signal corresponding to the other power transistor based on a skipping value, wherein the skipping value defines a number of switching cycles to be skipped in a predetermined number of switching cycles.

In one example the temperature equilibration unit is further configured to determine the skipping value based on a temperature difference between the first power transistor and the second power transistor.

## Claims

1. A gate drive circuit for driving at least a first and a second power transistor between switching states, wherein the first and second power transistor are arranged in parallel between a first load node and a second load node, the gate drive circuit comprising:
a control signal input node configured to receive a common control signal,
a first temperature input node configured to receive a first temperature signal indicative of a temperature of the first power transistor,
a second temperature input node configured to receive a second temperature signal indicative of a temperature of the second power transistor,
a delay determination unit configured to determine a delay signal comprising at least one of a turn-on delay value and a turn-off delay value based on a comparison of the temperature of the first power transistor and the temperature of the second power transistor,
a drive signal generation unit configured to generate a first drive signal for driving the first power transistor and a second drive signal for driving the second power transistor based on the common control signal and the delay signal such that a time difference between a turn-on timing of the first drive signal and a turn-on timing of the second drive signal corresponds to the turn-on delay value and/or such that a time difference between a turn-off timing of the first drive signal and a turn-off timing of the second drive signal corresponds to the turn-off delay value,
a first driver stage configured to provide the first drive signal at a first driving node configured to be coupled to a control node of the first power transistor, and
a second driver stage configured to provide the second drive signal at a second driving node configured to be coupled to a control node of the second power transistor.

2. The gate drive circuit of claim 1, wherein the delay determination unit is configured for determining the turn-on delay value and/or the turn-off delay value based on a temperature difference between the temperature of the first power transistor and the second power transistor such that the power transistor having the higher temperature is turned on after and/or turned off before the power transistor having the lower temperature.

3. The gate drive circuit of claim 1 or 2, wherein the turn-on timing of at least one of the first drive signal and the second drive signal is synchronized to a turn-on timing of the common control signal, and the turn-off timing of at least one of the first drive signal and the second drive signal is synchronized to a turn-off timing of the common control signal.

4. The gate drive circuit of any one of the preceding claims, wherein the turn-on delay value and/or the turn-off delay value is proportional to a temperature difference between the first power transistor and the second power transistor.

5. The gate drive circuit of any one of the preceding claims, wherein the turn-on delay value and/or the turn-off delay value are at most 1%, preferably at most 0.1%, of a reference time period of the common control signal.

6. The gate drive circuit of any one of the preceding claims, further comprising:
a first voltage domain and a second voltage domain that is electrically isolated from the first voltage domain, and
a signal transmission circuit configured for transmitting a signal from the first voltage domain to the second voltage domain, wherein
the control signal input node is arranged in the first voltage domain, and
the first temperature input node, the second temperature input node, the delay determination unit, the drive signal generation unit, the first driver stage and the second driver stage are arranged in the second voltage domain.

7. The gate drive circuit of any one of claims 1 to 5, comprising:
a primary driver unit corresponding to the first power transistor and a secondary driver unit corresponding to the second power transistor, each of the primary driver unit and the secondary driver unit comprising a respective control signal input node and a respective driver stage configured to provide a respective drive signal at a respective driving node, and
the primary driver unit and the secondary driver unit each comprising a respective communication interface configured for communication with the respective other driver unit, and wherein
the delay determination unit is arranged in the primary driver unit.

8. The gate drive circuit of any one of the preceding claims, wherein the delay determination unit is configured to determine the turn-on delay value corresponding to the power transistor having the higher temperature to be 100% of an on-time period of the common control signal, and wherein the drive signal generation unit is configured to generate the drive signal of the corresponding power transistor based on the common control signal and the delay signal such that the corresponding drive signal is maintained at a low value during at least one switching cycle of the common control signal.

9. The gate drive circuit of the preceding claim, wherein the drive signal generation unit is configured to generate the corresponding drive signal based on a skipping value, wherein the skipping value defines a number of switching cycles to be skipped in a predetermined number of switching cycles, such that the corresponding drive signal is maintained at a low value in accordance with the skipping value.

10. The gate drive circuit of the preceding claim, wherein the delay determination unit is further configured to determine the skipping value based on the comparison of the temperature of the first power transistor and the temperature of the second power transistor.

11. The gate drive circuit of any one of the preceding claims, further comprising:
a third temperature input node configured to receive a third temperature signal indicative of a temperature of a third power transistor arranged between the first load node and the second load node in parallel to the first and second power transistor, and wherein
the delay determination unit is configured to determine the delay signal to further comprise at least one of a further turn-on delay value and a further turn-off delay value based on a comparison of the temperature of the first power transistor and the temperature of the third power transistor,
the drive signal generation unit is configured to generate a third drive signal for driving the third power transistor based on the common control signal and the delay signal such that a time difference between a turn-on timing of the first drive signal and a turn-on timing of the third drive signal corresponds to the further turn-on delay value and/or such that a time difference between a turn-off timing of the first drive signal and a turn-off timing of the third drive signal corresponds to the further turn-off delay value, and further comprising
a third driver stage configured to provide the third drive signal at a third driving node configured to be coupled to a control node of the third power transistor.

12. The gate drive circuit of any one of the preceding claims, further comprising:
the first power transistor coupled between the first load node and the second load node and coupled to the first driving node,
the second power transistor coupled between the first load node and the second load node and coupled to the second driving node,
a first temperature sensor configured to measure a temperature of the first power transistor and coupled to the first temperature input node, and
a second temperature sensor configured to measure a temperature of the second power transistor and coupled to the second temperature input node.

13. A method for determining drive signals for driving of a first and a second power transistor between switching states, wherein the first and second power transistor are arranged in parallel between a first load node and a second load node, the method comprising:
determining a temperature of the first power transistor and a temperature of the second power transistor,
determining a turn-on delay value and/or a turn-off delay value based on a comparison of the temperature of the first power transistor and the temperature of the second power transistor, and
determining a first drive signal corresponding to the first power transistor and a second drive signal corresponding to the second power transistor based on a common control signal such that a time difference between a turn-on timing of the first drive signal and a turn-on timing of the second drive signal corresponds to the turn-on delay value and/or a time difference between a turn-off timing of the first drive signal and a turn-off timing of the second drive signal corresponds to the turn-off delay value.

14. A primary gate drive circuit configured for driving a first power transistor between switching states, the primary gate drive circuit being specifically adapted to be used in combination with at least one secondary gate drive circuit according to claim 15 that is configured for driving at least one second power transistor between switching states, wherein the first and at least one second power transistor are arranged in parallel between a first load node and a second load node, the primary gate drive circuit comprising:
a control signal input node configured to receive a common control signal,
a first temperature input node configured to receive a first temperature signal indicative of a temperature of the first power transistor,
at least one second temperature input node configured to receive a respective second temperature signal indicative of a temperature of the at least one second power transistor,
a delay determination unit configured to determine a respective turn-on delay value corresponding to each respective one of the first power transistor and the at least one second power transistor, and/or a respective turn-off delay value corresponding to each respective one of the first power transistor and the at least one second power transistor, based on a comparison of the temperature of the first power transistor and the respective temperature of the at least one second power transistor,
a communication interface configured to be coupled to a corresponding communication interface of the at least one secondary gate drive circuit and to transmit the respective turn-on delay value and/or the respective turn-off delay value to the at least one secondary gate drive circuit;
a drive signal generation unit configured to generate a drive signal for driving the first power transistor based on the common control signal and the turn-on delay value and/or the turn-off delay value corresponding to the first power transistor such that a time difference between a turn-on timing of the common control signal and a turn-on timing of the drive signal corresponds to the turn-on delay value corresponding to the first power transistor and/or such that a time difference between a turn-off timing of the common control signal and a turn-off timing of the drive signal corresponds to the turn-off delay value corresponding to the first power transistor, and
a driver stage configured to provide the drive signal at a driving node configured to be coupled to a control node of the first power transistor.

15. A secondary gate drive circuit configured for driving a second power transistor between switching states, the secondary gate drive circuit being specifically adapted to be used in combination with the primary gate drive circuit of claim 14 that is configured for driving a first power transistor between switching states, wherein the first and second power transistor are arranged in parallel between a first load node and a second load node, the secondary gate drive circuit comprising:
a control signal input node configured to receive a common control signal,
a communication interface configured to be coupled to the communication interface of the primary gate drive circuit and to receive a turn-on delay value and/or a turn-off delay value;
a drive signal generation unit configured to generate a drive signal for driving the second power transistor based on the common control signal and the turn-on delay value and/or the turn-off delay value such that a time difference between a turn-on timing of the common control signal and a turn-on timing of the drive signal corresponds to the turn-on delay value and/or such that a time difference between a turn-off timing of the common control signal and a turn-off timing of the drive signal corresponds to the turn-off delay value, and
a driver stage configured to provide the drive signal at a driving node configured to be coupled to a control node of the second power transistor.
